**Europäisches Patentamt**

**European Patent Office**

**Office européen des brevets**

(19)

(11) Veröffentlichungsnummer: **0 197 512**
**B1**

(12) # EUROPÄISCHE PATENTSCHRIFT

(45) Veröffentlichungstag der Patentschrift:
**02.08.89**

(21) Anmeldenummer: **86104559.9**

(22) Anmeldetag: **03.04.86**

(51) Int. Cl.⁴: **H01L 31/02, H01L 31/10**

(54) **Lichtzündbarer Thyristor mit verlustarmer Zuführung der Ansteuerleistung.**

(30) Priorität: **12.04.85 DE 3513219**

(43) Veröffentlichungstag der Anmeldung:
**15.10.86 Patentblatt 86/42**

(45) Bekanntmachung des Hinweises auf die Patenterteilung:
**02.08.89 Patentblatt 89/31**

(84) Benannte Vertragsstaaten:
**BE DE FR GB SE**

(56) Entgegenhaltungen:
**EP-A- 0 021 352**
**EP-A- 0 053 020**
**DE-A- 2 736 460**
**GB-A- 1 529 145**
**US-A- 4 257 058**
**US-A- 4 374 393**

(73) Patentinhaber: **Siemens Aktiengesellschaft Berlin und München, Wittelsbacherplatz 2, D-8000 München 2(DE)**

(72) Erfinder: **Salanki, Tibor, Dr., Kulmbacher Strasse 1, D-8520 Erlangen(DE)**
Erfinder: **Kuhnert, Reinhold, Dr., Dachauer Strasse 140d, D-8000 München 19(DE)**
Erfinder: **Mitlehner, Heinz, Dr., Hohenzollernstrasse 104, D-8000 München 40(DE)**

ACTORUM AG

**Beschreibung**

Die Erfindung bezieht sich auf einen lichtzündbaren Thyristor nach dem Oberbegriff des Patentanspruchs 1.

Ein solcher Thyristor ist aus dem IPEC-Tagungsband 1983, Seiten 559-570, bekannt. Die Ansteuerleistung wird hierbei von einer Lichtquelle, z.B. Leuchtdiode, über einen flexiblen Lichtleiter zugeführt, dessen Ende am Gehäuse des Thyristors derart befestigt ist, daß sich sein Ausgang vor einem in den Gehäusemantel gasdicht eingefügten Fenster befindet. Im Inneren des Gehäuses wird die Zündleistung über einen vom Fenster zum lichtempfindlichen Bereich des Thyristors geführten, gebogenen Lichtleiterstab weitergeleitet, der in einer Ausnehmung des Kathodenkontaktteils gelagert ist. Nachteilig ist jedoch, daß durch die optischen Schnittstellen vor und hinter dem Fenster sowie durch nur schwer zu vermeidende Ungenauigkeiten bei der Montage des Lichtleiterstabes und des flexiblen Lichtleiters die übertragbare Lichtleistung herabgesetzt wird, was insbesondere deswegen ins Gewicht fällt, weil die zur Verfügung stehenden Lichtquellen zur Aufbringung der erforderlichen Ansteuerleistung im Leistungsgrenzbereich betrieben werden müssen.

EP-A 0 021 352 beschreibt einen lichtzündbaren Thyristor, in dem ein Lichtleiter, der von einer starren Hülse umgeben ist, in einer Bohrung des Kathodenkontaktteils befestigt ist.

Der Erfindung liegt die Aufgabe zugrunde, einen lichtzündbaren Thyristor der eingangs genannten Art anzugeben, der mit einer möglichst großen Zündleistung beaufschlagt werden kann, ohne daß hierbei große Übertragungsverluste in Kauf genommen werden müssen. Das wird erfindungsgemäß durch eine Ausbildung nach dem kennzeichnenden Teil des Patentanspruchs 1 erreicht.

Der mit der Erfindung erzielbare Vorteil liegt insbesondere darin, daß durch die Reduktion der Zahl der optischen Schnittstellen und durch die Selbstjustierung des Lichtleiters im hülsenförmigen Einsatz ein wesentlich größerer Teil der zur Verfügung stehenden Lichtleistung dem lichtempfindlichen Bereich des Thyristors zugeführt werden kann als bisher. Weiterhin wird die Montage eines solchen Thyristors erheblich erleichtert.

Eine Teilaufgabe, die mit einer im Anspruch 2 angegebenen Weiterbildung des erfindungsgemäßen Thyristors zusätzlich gelöst wird, besteht darin, eine einfache Montage und Austauschbarkeit des Thyristors im Rahmen eines Säulenaufbaus mehrerer gleichartiger Thyristoren zu gewährleisten.

Die Ansprüche 3 bis 11 sind auf andere bevorzugte Ausgestaltungen und Weiterbildungen der Erfindung gerichtet.

Die Erfindung wird nachfolgend anhand der Zeichnung näher erläutert. Dabei zeigt:

Fig. 1 einen erfindungsgemäß ausgebildeten lichtzündbaren Thyristor und

Fig. 2 einen Lichtleiter, der zur Zuführung der Ansteuerleistung für einen Thyristor nach Fig. 1 dient.

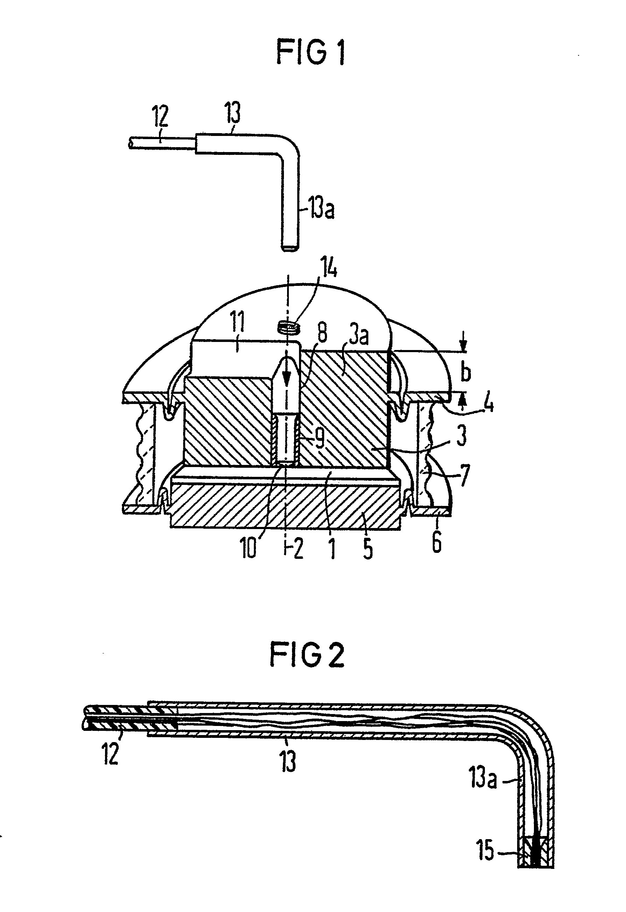

Figur 1 zeigt einen Querschnitt durch den Gesamtaufbau eines erfindungsgemäß ausgebildeten, lichtzündbaren Hochleistungsthyristors. Dabei bezeichnet 1 eine an sich bekannte Thyristortablette, d.h. einen Körper aus dotiertem Halbleitermaterial, z.B. Silizium, der vier aufeinanderfolgende Schichten abwechselnder Leitfähigkeitstypen (n-Emitter, p-Basis, n-Basis, p-Emitter) aufweist und zur Erhöhung seiner Spannungsfestigkeit randseitig abgeschrägt ist. Er bildet eine flache, zu einer Achse 2 rotationssymmetrische Scheibe. Die Kontaktierung des n-Emitters erfolgt über ein gegebenenfalls mit einem nicht dargestellten, ersten Anschluß eines Laststromkreises versehenes Kathodenkontaktteil 3, das einen flanschartigen Ansatz 4 hat. Der p-Emitter steht mit einem Anodenkontaktteil 5 in Verbindung, das mit einem flanschartigen Ansatz 6 versehen ist. Das Teil 5 weist gegebenenfalls einen zweiten, nicht dargestellten Anschluß für den Laststromkreis auf. Ein zylinderförmiger Keramikmantel 7 ist mit den Teilen 4 und 6 vorzugsweise gasdicht verschweißt. Oberhalb von 3 kann in an sich bekannter Weise ein Kühlkörper vorgesehen sein, der mit dem Teil 3 sowie mit der Thyristortablette 1 in einem guten Wärmekontakt steht.

Das Kathodenkontaktteil 3 ist im Bereich der Achse 2 mit einer zu den horizontalen Hauptflächen der Thyristortablette 1 etwa senkrecht verlaufenden, durchgehenden Bohrung 8 versehen, in die ein hülsenförmiger, insbesondere metallischer Einsatz 9 eingefügt ist. Zweckmäßigerweise ist der Einsatz 9, der z.B. aus Messing besteht, an seinem unteren Ende mit einem transparenten Abschlußteil 10 versehen, das planparallel oder als plankonvexe Sammellinse ausgebildet sein kann. Das Abschlußteil 10 ist dabei gasdicht in den Einsatz 9 eingepaßt, der seinerseits gasdicht in die Bohrung 8 eingelötet bzw. eingeschweißt ist.

Ein zentraler Bereich 3a des Kathodenkontaktteils 3 ist gegenüber dem flanschartigen Ansatz 4 um das in Fig. 1 mit b bezeichnete Maß erhöht ausgebildet. Dieser Bereich ist mit einer nutförmigen Ausnehmung 11 versehen, die von seiner oberen, in Fig. 1 sichtbaren Grenzfläche ausgeht und im wesentlichen eine konstante Tiefe aufweist. Sie erstreckt sich vom seitlichen Rand des Teils 3a bis zur Mitte desselben, wo sie in die Bohrung 8 einmündet.

Zur Zuführung der Ansteuerleistung dient ein Lichtleiter 12, der endseitig von einer starren Hülse 13 umgeben ist. Diese weist ein thyristorseitiges Teil 13a auf, das gegenüber dem vorderen Hülsenteil etwa um einen Winkel von 90° abgebogen ist. Das Ende des Lichtleiters 12 fällt dabei mit dem thyristorseitigen Ende des Teils 13a zusammen. Die Länge von 13a ist auf die Länge der Bohrung 8 soweit abgestimmt, daß das Ende des Lichtleiters 12 möglichst nahe an das Abschlußteil 10 heranreicht, wobei der Außendurchmesser der Hülse 13 so gewählt ist, daß ihr thyristorseitiges Ende in den hülsenförmigen Einsatz 9 ohne seitliches Spiel einsteckbar ist. Im eingesteckten Zustand wird dann der nicht abgewinkelte Teil der Hülse 13 im wesentlichen von der nutförmigen Ausnehmung 11 aufgenommen. Mit Vorteil ist in die Ausnehmung 11 ein Federungselement, z.B. eine Spiralfeder 14, so eingelegt, daß es von oben auf die eingesteckte Hülse 13 drückt und den Lichtleiter 12 gegenüber dem Abschlußteil 10 in einer Arbeitslage fixiert, in der das Ende von 12 dem Abschlußteil 10 möglichst weitgehend angenähert ist. Falls ein Kühlkörper vorgesehen ist, der sich an die in Fig. 1 sichtbare obere Fläche des zentralen Bereichs 3a anlegt, so stützt sich das Federungselement zweckmäßigerweise gegen die Unterseite dieses Kühlkörpers ab.

Die über die flanschartigen Ansätze 4 und 6 mit dem Keramikmantel 7 verbundenen Teile 3 und 5 bilden ein gasdichtes Gehäuse für die Thyristortablette 1, wobei die Bohrung 8 durch den zylinderförmigen Einsatz 9 und das Abschlußteil 10 ebenfalls gasdicht abgeschlossen ist. Durch das Einstecken des mit der Hülse 13 versehenen Lichtleiters 12 in den Einsatz 9 gelingt es, den Lichtleiter 9 ohne umständlich zu montierende Schraubverbindungen in einen guten optischen Kontakt mit der Thyristortablette 1 zu bringen, so daß ein großer Teil der über den Lichtleiter 12 zugeführten Ansteuerleistung für die Zündung des Thyristors zur Verfügung steht. Wegen der mit der Erfindung erzielbaren Reduzierung der optischen Verluste brauchen die die Ansteuerleistung aufbringenden Lichtquellen nicht mehr in ihrem absoluten Leistungsgrenzbereich betrieben zu werden, was ihr Alterungsverhalten verbessert und damit die Einsatzbereitschaft sowohl einer einzelnen Thyristoranordnung als auch die einer Mehrzahl solcher Anordnungen, die in einem säulenartigen Aufbau zusammengefaßt sind, wesentlich erhöht. Der Austausch einer einzelnen solchen Thyristoranordnung innerhalb eines säulenartigen Aufbaus kann in einfacher Weise durch seitliches Herausschieben der aus den Teilen 1 bis 11 bestehenden Baueinheit erfolgen. Nach dem Herausziehen des mit der Hülse 13 versehenen Lichtleiters 12 wird dieser dann in den Einsatz 9 einer neuen, entsprechend ausgebildeten Baueinheit eingesteckt, worauf diese dann in die Säule seitlich eingeschoben wird.

In Fig. 2 ist eine bevorzugte Ausführungsform des mit einer starren Hülse 13 versehenen Lichtleiters 12 dargestellt. Die Hülse 13, die aus Metall, z.B. Messing, besteht, wird dabei zunächst mit einem Ende auf die Kunststoffumhüllung des Lichtleiters 12 aufgeschoben, wobei das von der Umhüllung befreite Ende des Lichtleiters, der nach Fig. 2 aus einem Faserbündel besteht, im Inneren der Hülse 13 verläuft. Das thyristorseitige Ende der Hülse ist mit einem Verschlußteil 15 versehen, das im zentralen Bereich seines Querschnitts vom Lichtleiter durchdrungen wird. Zur Hochspannungsstabilisierung kann eine härtbare Verschlußmasse, z.B. eine Epoxidharzmasse, in die Hülse 13 eingefüllt werden.

Abweichend von den bisher beschriebenen Ausführungsformen der Erfindung kann bei der starren Hülse 13 das abgewinkelte Teil 13a auch entfallen. In diesem Fall wird der Lichtleiter 12 von oben in die Bohrung 8 und den Einsatz 9 eingesteckt, was allerdings den Einsatz des Thyristors in einem säulenartigen Aufbau mehrerer gleichartiger Thyristoren nicht mehr erlaubt.

## Patentansprüche

1. Lichtzündbarer Thyristor mit einem Kathodenkontaktteil (3) und einem zur Zuführung der Ansteuerleistung dienenden, in einer Bohrung (8) des Kathodenkontaktteils (3) angeordneten Lichtleiter (12), der mit einem lichtempfindlichen Bereich des Thyristors (1) in optischem Kontakt steht, **dadurch gekennzeichnet**, daß ein hülsenförmiger Einsatz (9) in die Bohrung eingefügt ist, daß das thyristorseitige Ende des Lichtleiters von einer starren Hülse (13) umgeben ist, daß die Hülse (13) oder ein thyristorseitiges, insbesondere abgewinkeltes Teil (13a) derselben der Bohrung (8) des Kathodenkontaktteils (3) längenmäßig etwa entspricht und daß die Hülse (13) oder das thyristorseitige Teil (13a) derselben in den hülsenförmigen Einsatz (9) einsteckbar ist.

2. Lichtzündbarer Thyristor nach Anspruch 1, **dadurch gekennzeichnet**, daß das Kathodenkontaktteil (3) einen flanschartigen Ansatz (4) aufweist, der mit einem Keramikmantel (7) gasdicht verschweißt oder verlötet ist, daß ein zentraler Bereich (3a) des Kathodenkontaktteils (3) gegenüber dem flanschartigen Ansatz (4) erhöht ist, daß eine Außenfläche des zentralen Bereichs (3a) mit einer nutförmigen Ausnehmung (11) versehen ist, die in die Bohrung (8) einmündet und daß die Hülse (13) im eingesteckten Zustand ihres abgewinkelten, thyristorseitigen Teils (13a) im wesentlichen von der Ausnehmung (11) aufgenommen wird.

3. Lichtzündbarer Thyristor nach Anspruch 1 oder 2, **dadurch gekennzeichnet**, daß die starre Hülse (13) an ihrem thyristorseitigen Ende mit einem Verschlußteil (15) versehen ist, das vom Lichtleiter im zentralen Bereich seines Querschnitts durchdrungen wird.

4. Lichtzündbarer Thyristor nach Anspruch 3, **dadurch gekennzeichnet**, daß die starre Hülse (13) mit einer den Lichtleiter (12) umgebenden härtbaren Vergußmasse, insbesondere einer Epoxidharzmasse, ausgefüllt ist.

5. Lichtzündbarer Thyristor nach Anspruch 4, **dadurch gekennzeichnet**, daß die starre Hülse (13) vor dem Einbringen der Vergußmasse ihre abgewinkelte Form (13, 13a) erhält.

6. Lichtzündbarer Thyristor nach einem der Ansprüche 1 bis 5, **dadurch gekennzeichnet**, daß der hülsenförmige Einsatz (9) mit einem transparenten, insbesondere planparallel oder als Sammellinse ausgebildeten Abschlußteil (10) versehen und in die Bohrung (8) des Kathodenkontaktteils (3) gasdicht eingelötet bzw. eingeschweißt ist.

7. Lichtzündbarer Thyristor nach einem der Ansprüche 1 bis 6, **dadurch gekennzeichnet**, daß er im wesentlichen rotationssymmetrisch ausgebildet ist und daß sich die Bohrung (8) des Kathodenkontaktteils (3) im Bereich der Symmetrieachse (2) befindet.

8. Lichtzündbarer Thyristor nach einem der vorhergehenden Ansprüche, **dadurch gekennzeichnet**, daß das Kathodenkontaktteil (3, 4) und der Keramikmantel (7) mit einem Anodenkontaktteil (5, 6) zu einem gasdichten Gehäuse zusammengefügt sind.

9. Lichtzündbarer Thyristor nach einem der vorhergehenden Ansprüche, **dadurch gekennzeichnet**,

daß ein Kühlkörper vorgesehen ist, der an das Kathodenkontaktteil (3) angrenzt.

10. Lichtzündbarer Thyristor nach einem der Ansprüche 2 bis 9, **dadurch gekennzeichnet,** daß in der nutförmigen Ausnehmung (11) des zentralen Bereichs (3a) des Kathodenkontaktteils ein die Arbeitslage des Lichtleiters (12) zusätzlich definierendes Federungselement (14), insbesondere eine Spiralfeder, vorgesehen ist.

11. Lichtzündbarer Thyristor nach Anspruch 9 und 10, **dadurch gekennzeichnet,** daß sich das Federungselement gegen den Kühlkörper abstützt.

## Revendications

1. Thyristor pouvant être déclenché par la lumière ou photothyristor, comprenant une pièce de contact de cathode (3) et un conducteur de lumière (12) servant à l'amenée de la puissance d'attaque et disposé dans un perçage (8) de la pièce de contact de cathode (3), conducteur de lumière qui est en contact optique avec une zone photosensible du thyristor (1), caractérisé en ce qu'une pièce (9) en forme de manchon est insérée dans le perçage, que l'extrémité côté thyristor du conducteur de lumière est entourée par un tube rigide (13), que le tube (13) ou une partie (13a) de ce tube, située du côté du thyristor, en particulier une partie coudée, possède une longueur qui correspond à peu près à celle du perçage (8) de la pièce de contact de cathode (3) et que le tube (13) ou sa partie (13a) côté thyristor peut être enfiché dans la pièce insérée (9) en forme de manchon.

2. Thyristor selon la revendication 1, caractérisé en ce que la pièce de contact de cathode (3) présente une saillie en forme de collerette (4) qui est soudée ou brasée étanche au gaz à une enveloppe (7) en céramique, qu'une zone centrale (3a) de la partie de contact de cathode (3) est rehaussée par rapport à la collerette (4), qu'une surface externe de la zone centrale (3a) est pourvue d'un évidement (11) en forme de rainure, qui débouche dans le perçage (8), et que le tube (13), après l'enfichage de sa partie coudée (13a) située du côté du thyristor est reçu, pour l'essentiel, par l'évidement (11).

3. Thyristor selon la revendication 1 ou 2, caractérisé en ce que le tube rigide (13) est pourvu, à son extrémité côté thyristor, d'une partie obturatrice (15) qui est traversée par le conducteur de lumière dans la région centrale de sa section.

4. Thyristor selon la revendication 3, caractérisé en ce que le tube rigide (13) est rempli par une masse de scellement durcissable qui entoure le conducteur de lumière (12), en particulier par une masse de résine époxy.

5. Thyristor selon la revendication 4, caractérisé en ce que le tube rigide (13) reçoit sa forme coudée (13, 13a) avant l'introduction de la masse de scellement.

6. Thyristor selon une des revendications 1 à 5, caractérisé en ce que la pièce insérée (9) en forme de manchon est pourvue d'une partie terminale (10) transparente, ayant en particulier des faces planes et parallèles ou qui est réalisée comme une lentille convexe, et qui est soudée ou brasée étanche au gaz dans le perçage (8) de la pièce de contact de cathode (3).

7. Thyristor selon l'une des revendications 1 à 6, caractérisé en ce qu'il est réalisé essentiellement à symétrie de révolution et que le perçage (8) de la pièce de contact de cathode (3) se trouve dans la région de l'axe de symétrie (2).

8. Thyristor selon une des revendications précédentes, caractérisé en ce que la pièce de contact de cathode (3, 4) et l'enveloppe en céramique (7) sont réunies à une pièce de contact d'anode (5, 6) pour former un boîtier étanche au gaz.

9. Thyristor selon une des revendications précédentes, caractérisé en ce qu'il est équipé d'un refroidisseur voisin de la pièce de contact de cathode (3).

10. Thyristor selon une des revendications 2 à 9, caractérisé en ce qu'un élément de montage élastique (14), notamment un ressort spiral, est prévu dans l'évidement (11) en forme de rainure de la zone centrale (3a) de la pièce de contact de cathode, pour définir en tant qu'élément supplémentaire la position de travail du conducteur de lumière (12).

11. Thyristor selon les revendications 9 et 10, caractérisé en ce que l'élément de montage élastique est appuyé sur le refroidisseur.

## Claims

1. Light-activated thyristor with a cathode contact (3) and a light guide (12), which serves to supply the control power, is arranged in a bore (8) of the cathode contact piece (3), and is in optical contact with a light-sensitive region of the thyristor (1), characterized in that a sleeve-shaped insert (9) is inserted into the bore, in that the thyristor-neighbouring end of the light guide is surrounded by a rigid sleeve (13), in that the sleeve (13) or a thyristor-neighbouring, especially a kinked, part (13a) of the same corresponds approximately in length to the bore (8) of the cathode contact piece (3), and in that the sleeve (13) or the thyristor-neighbouring part (13a) of the same can be slipped into the sleeve-shaped insert (9).

2. Light-activated thyristor according to Claim 1, characterized in that the cathode contact piece (3) has a flange-like projection (4), which is welded or soldered gas-tight to a ceramic cladding (7), in that a central region (3a) of the cathode contact piece (3) is raised as compared with the flange-like projection (4), in that an outer face of the central region (3a) is provided with a groove-shaped recess (11) which leads into the bore (8), and in that when its kinked, thyristor-neighbouring part (13a) has been slipped in, the sleeve (13) is essentially accommodated the recess (11).

3. Light-activated thyristor according to Claim 1 or 2, characterized in that, at its thyristor-neighbouring end, the rigid sleeve (13) is provided with a closing part (15), which is penetrated by the light guide in the central region of its cross-section.

4. Light-activated thyristor according to Claim 3, characterized in that the rigid sleeve (13) is filled up with a hardenable filling compound, especially an epoxy resin compound, surrounding the light guide (12).

5. Light-activated thyristor according to Claim 4, characterized in that the rigid sleeve (13) receives its kinked form (13), 13a) before the introduction of the filling compound.

6. Light-activated thyristor according to one of Claims 1 to 5, characterized in that the sleeve-shaped insert (9) is provided with a transparent terminating part (10), particularly designed to be plane-parallel or as a collecting lens, and is soldered or welded gas-tight into the bore (8) of the cathode contact piece (3).

7. Light-activated thyristor according to one of Claims 1 to 6, characterized in that it is designed to be essentially rotationally symmetric, and in that the bore (8) of the cathode contact piece (3) is located in the region of the axis of symmetry (2).

8. Light-activated thyristor according to one of the preceding claims, characterized in that the cathode contact piece (3, 4) and the ceramic cladding (7) are combined with an anode contact piece (5, 6) to form a gas-tight housing.

9. Light-activated thyristor according to one of the preceding claims, characterized in that a heat sink is provided, which adjoins the cathode contact piece (3).

10. Light-activated thyristor according to one of Claims 2 to 9, characterized in that there is provided in the groove-shaped recess (11) of the central region (3a) of the cathode contact piece a resilient element (14), particularly a spiral spring, which element additionally defines the operative position of the light guide (12).

11. Light-activated thyristor according to Claims 9 and 10, characterized in that the resilient element is supported against the heat sink.

# FIG 1

# FIG 2